Europäisches Patentamt

European Patent Office

Office européen des brevets

(11) Veröffentlichungsnummer: **0 424 554 A1**

# (12) EUROPÄISCHE PATENTANMELDUNG

(21) Anmeldenummer: 89119646.1

(51) Int. Cl.⁵: **H03M 9/00**

(22) Anmeldetag: 23.10.89

(43) Veröffentlichungstag der Anmeldung:
**02.05.91 Patentblatt 91/18**

(84) Benannte Vertragsstaaten:
**AT BE CH DE FR GB IT LI NL SE**

(71) Anmelder: **Siemens Aktiengesellschaft**
**Wittelsbacherplatz 2**
**W-8000 München 2(DE)**

(72) Erfinder: **Müller, Rudi, Dr. Dipl. Phys.**
**Von Branca Strasse 35**
**W-8038 Gröbenzell(DE)**

(54) Mehrstufiger Seriell-zu-Parallel- und/oder Parallel-zu-Seriell-Umsetzer.

(57) In einer Schaltungsanordnung zur Umsetzung von langen Datenworten paralleler Struktur in Datenworte serieller Struktur und/oder umgekehrt wird das umzusetzende Datenwort abschnittsweise in einem Schieberegister mit seriellen und parallelen Anschlüssen, dessen Länge einem Digitalwortabschnitt entspricht nacheinander umgesetzt, wobei die Taktlasten und bei hoher Datenrate die Verlustleistungswerte erheblich reduziert werden.

FIG 1

EP 0 424 554 A1

# MEHRSTUFIGER SERIELL-ZU-PARALLEL- UND/ODER PARALLEL-ZU-SERIELL-UMSETZER

Während in digitalen Datenendeinrichtungen die Verarbeitung von binären Daten in der Regel in paralleler Datenstruktur erfolgt, bevorzugt man für die Übertragung von binären Daten zwischen Daten-Endeinrichtungen, wie sie beispielsweise durch eine Verbindung zwischen Datenendgeräten eines LAN (local area network) gegeben sein kann, die serielle Datenstruktur.

Zur bidirektionalen Umsetzung von in paralleler Struktur vorliegender Datenworte und in serieller Struktur vorliegender Datenworte ist beispielsweise aus dem SIEMENS-Datenbuch Microprozessorbausteine, Ausgabe 1976/77, der Baustein SAB 8251 bekannt, der Funktionsblöcke aufweist, die durch einen internen Datenbus und Steuerleitungen verbunden sind. Zu den Funktionsblöcken gehören ein Seriell/Parallel-Umsetzer, ein Parallel/Seriell-Umsetzer, ein Register zur Pufferung von in paralleler Struktur vorliegender Daten und verschiedene Steuerungen.

In diesem Baustein werden stets Datenworte in der gesamten Datenwortlänge, im gegebenen Fall von 8 Bit Länge, umgesetzt. Wendet man das gegebene Konzept auf die Umsetzung von langen Datenworten, wie sie beispielsweise durch Datenworte mit einer Länge von 512 Bit gegeben sein können, an, so verursacht die hohe Anzahl von gleichzeitig erfolgenden Umschaltungen während eines Taktschrittes hohe Belastungsspitzen der speisenden Betriebsspannungsquelle und damit hohe Taktlasten. Ist neben der Länge der zu verarbeitenden Datenworte die Datenrate hoch, so resultiert daraus eine entsprechend hohe Verlustleistung. Weiterhin ist es bei der Seriell/Parallel-Umsetzung und hohen Datenraten schwierig, kontinuierlich in das lange Schieberegister einlaufende serielle Daten in ein Register zu übernehmen bzw. bei der parallel/Seriell-Umsetzung das gesamte Schieberegister zu laden, da für diesen Vorgang jeweils weniger als eine Bit- Zeit zur Verfügung steht.

Die Erfindung stellt sich die Aufgabe, eine Schaltungsanordnung zur Umsetzung langer Datenworte von in paralleler Struktur vorliegenden Datenworte in in serieller Struktur vorliegende Datenworte und/oder umgekehrt anzugeben, die die oben angegebenen Nachteile vermeidet.

Die Erfindung betrifft eine Schaltungsanordnung zur Umsetzung von in paralleler Struktur vorliegender Datenworte in in serieller Struktur vorliegender Datenworte und/oder umgekehrt unter Einsatz eines Schieberegisters mit seriellem Anschluß und parallelem Anschluß, einem Datenbus, der den parallelen Anschluß mit einer Anzahl von Registern verbindet, einer Mehrzahl von Steuerleitungen und einer Ablaufsteuerung, dadurch gekennzeichnet, daß das umzusetzende Datenwort durch die Ablaufsteuerung in Abschnitte geteilt wird, die einerseits kleiner als die Datenwortlänge sind und andererseits der Bit-Länge des Schieberegisters entsprechen wobei diese Datenwortabschnitte nacheinander in dem Schieberegister umgesetzt werden.

Die Erfindung bringt den Vorteil mit sich, daß der Aufwand für das Schieberegister, in dem die eigentliche Seriell/Parallel-bzw. Parallel/Seriell-Umsetzung stattfindet, nur für einen Bruchteil der gesamten Datenwortlänge erbracht werden muß, wobei zudem eine hohe Datenrate leichter handhabbar ist. Aus der Aufteilung in einen kleinen Schaltungsabschnitt mit hoher Verarbeitungsgeschwindigkeit und in einen demgegenüber großen Schaltungsabschnitt mit langsamer Verarbeitungsgeschwindigkeit ergeben sich darüberhinaus erheblich verringerte Werte für die auftretenden Taktlasten und die Verlustleistung.

In weiterer Ausgestaltung der Erfindung können die Signale zur Steuerung der Register binär codiert zu den Registern übertragen werden und dort decodiert werden. Diese Maßnahme bringt den Vorteil einer Reduzierung der erforderlichen Anzahl von Steuerleitungen mit sich.

Einer anderen Ausführungsform der Erfindung zufolge werden die Register dadurch nacheinander angesteuert, daß ein Registerfreigabesignal durch registerindividuelle, das jeweilige Register steuernde Steuer-Schieberegisterstufen geschoben wird. Diese Maßnahme bringt eine erhebliche Reduzierung der Anzahl von die Register steuernden Steuerleitungen mit sich.

In weiterer Ausgestaltung der Erfindung wird der ersten Steuer-Schieberegisterstufe zu Beginn einer Datenwortumsetzung das Registerfreigabesignal zugeführt. Diese Maßnahme stellt den richtigen Ausgangszustand des mit den Steuer-Schieberegisterstufen gebildeten Steuer-Schieberegisters zu Beginn einer Datenwortumsetzung sicher.

In weiterer Ausgestaltung der Erfindung bilden die Steuer-Schieberegisterstufen ein im Ring geschlossenes Schieberegister. Durch diese Maßnahme wird das wiederholte Setzen des Registerfreigabesignals zu Beginn jeder Datenwortumsetzung vermieden.

In weiterer Ausgestaltung der Erfindung sind die Steuer-Schieberegisterstufen jeweils mit der Serienschaltung eines ersten Transmission Gates, eines ersten Inverters, eines zweiten Transmission Gates und eines zweiten Inverters gebildet, wobei das zweite Transmission Gate mit den gegenüber dem ersten Transmission Gate zugeführten Steuersignalen komplementären Steuersignalen gesteuert wird. Diese Anordnung bildet eine besonders aufwandarme Ausführungsform der Steuer-Schieberegisterstufen.

Weitere Besonderheiten der Erfindung werden aus der nachfolgenden näheren Erläuterung der Erfindung anhand der Zeichnungen ersichtlich. Dabei zeigen

Fig. 1 das Schema eines erfindungsgemäßen Seriell/Parallel-Parallel/Seriell-Umsetzers,

Fig. 2 die Darstellung von Einzelheiten einer Ausführungsform,

Fig. 3 die schaltungstechnische Realisierung von Einzelheiten entsprechend Fig. 2,

Fig. 4 die Darstellung von Einzelheiten einer anderen Ausführungsform,

Fig. 5 die schaltungstechnische Realisierung von Einzelheiten entsprechend Fig. 4.

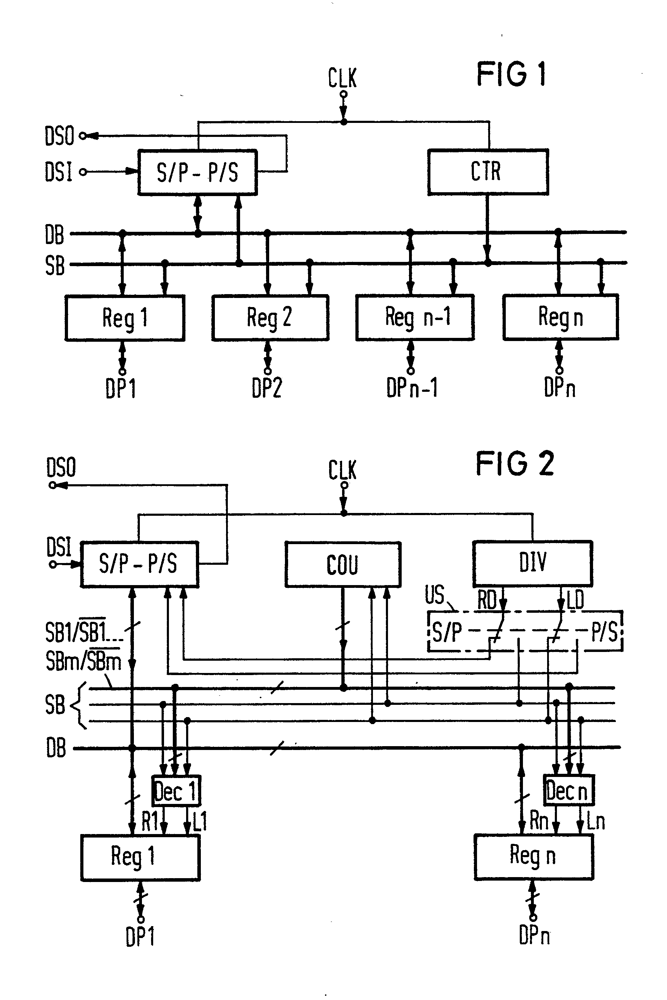

In Fig. 1 ist in zum Verständnis der Erfindung erforderlichem Umfang eine Schaltungsanordnung zur bidirektionalen Seriell/Parallel-Parallel/Seriell-Umsetzung langer Datenworte skizziert. Ein Seriell/Parallel-Parallel/Seriell-Umsetzer S/P-P/S ist mit einem Schieberegister gebildet, das eine Bit-Länge, die einem Bruchteil der umzusetzenden Datenwortlänge entspricht, das einen seriellen Eingang DSI und/oder einen seriellen Ausgang DSO, einen Steuereingang, über den das Schieberegister mit einem Taktsignal CLK beaufschlagt wird, einen Steuereingang, über den die Ausgabe des jeweiligen Schieberegisterinhalts auf einen an das Schieberegister angeschlossenen Datenbus DB bewirkt wird und einen Steuereingang, über den die Übernahme der jeweiligen auf dem Datenbus DB anstehenden Information in das Schieberegister bewirkt wird aufweist. Dieser Seriell/Parallel-Parallel/Seriell-Umsetzer S/P-P/S kann beispielsweise, insbesondere dann, wenn ein Datenstrom umgesetzt werden soll, der eine Datenrate aufweist, die im oberen Bereich der heute verarbeitbaren Datenrate liegt, mit einem in ECL (Emitter-Coupled-Logic)-Technologie aufgebauten Schieberegister gebildet sein. An den Datenbus DB ist eine Mehrzahl von Registern Reg1..Regn angeschlossen, wie sie beispielsweise durch handelsübliche CMOS-Bausteine mit der Bezeichnung 4034 gegeben sein können, die jeweils die gleiche Bit-Länge wie der S/P-P/S-Umsetzer aufweisen. Die Anzahl der Register Reg1..Regn, die jeweils zwei bidirektionale Datenanschlüsse aufweisen, ergibt sich aus der Bit-Länge der zu verarbeitenden Datenworte; für eine zu verarbeitende Datenwortlänge von beispielsweise 512 Bit werden bei einer Registerlänge von 8 Bit 64 Register Reg1.. Regn benötigt. Eine Ablaufsteuerung CTR, die von einer nicht näher dargestellten Taktquelle ebenso wie der S/P-P/S-Umsetzer mit einem Taktsignal CLK beaufschlagt wird, ist über einen Steuerbus 58 mit den Registern Reg1..Regn und mit dem S/P-P/S-Umsetzer verbunden.

Zunächst sei die Umsetzung eines langen Datenwortes, das in serieller Struktur vorliegt, in ein Datenwort in paralleler Struktur betrachtet.

Ausgehend von einem zu Beginn der Datenwortumsetzung vorliegenden Grundzustand zählt die Ablaufsteuerung CTR die Taktschritte CLK, während der die seriellen Daten über einen seriellen Datenanschluß DSI in den S/P-P/S-Umsetzer eingelesen werden, bis ein Wert erreicht ist, der der Länge des S/P-P/S-Umsetzers (beispielsweise 8 Bit) entspricht. Daraufhin bewirkt die Steuerung CTR über den Steuerbus SB die parallele Ausgabe des Datenwortabschnitts aus dem S/P-P/S-Umsetzer auf den Datenbus DB, der eine Anzahl von Datenleitungen entsprechend der Bit-Länge der S/P-P/S-Umsetzer aufweist, und die Übernahme dieses Datenwortabschnitts in ein erstes Register Reg1. In den darauffolgenden Zyklen werden die in den S/P-P/S-Umsetzer einlaufenden seriellen Daten wie oben beschrieben jeweils in das nächstfolgende Register Reg übernommen, bis schließlich das gesamte Datenwort in den Registern Reg1 ..Regn ansteht und zur weiteren Verarbeitung auf die parallelen Datenanschlüsse DP1..DPn ausgegeben werden kann.

Die Umsetzung von in paralleler Struktur vorliegender Datenworte in einen seriellen Datenstrom läuft entsprechend der Erfindung wie folgt ab:

Das an den parallelen Datenanschlüssen DP1..DPn, die jeweils eine Anzahl von Datenleitungen entsprechend der Registerlänge aufweisen, anstehende Datenwort wird zunächst in die Register Reg1..Regn übernommen. Ausgehend von einem zu Beginn der Umsetzung eines Datenwortes herrschenden Grundzustand steuert die Ablaufsteuerung CTR mit einem Takt, der gegenüber dem Taktsignal CLK um einen Faktor heruntergesetzt ist, der der Bit-Länge des S/P-P/S-Umsetzers entspricht (beispielsweise Faktor 8) beginnend bei dem Register Reg1 die sequentielle Übernahme der Daten aus den Registern Reg1..Regn über den Datenbus DB in den S/P-P/S-Umsetzer, von wo die Daten bitweise mit dem Takt CLK auf einen seriellen Datenanschluß DSO ausgegeben werden. Aus der beschriebenen Funktionsweise ist zu erkennen, daß jeweils nur ein Bruchteil der gesamten umzusetzenden Datenwortlänge mit dem schnellen Taktsignal CLK zu verarbeiten ist. Es sei hier darauf hingewiesen, daß im Falle der Seriell/Parallel-Umsetzung, bei der ein kontinuierlicher Datenstrom zu verarbeiten ist, oder im Falle der Parallel/Seriell-Umsetzung, bei der die Weiterverarbeitung der in Paralleler Struktur anliegenden Daten nicht innerhalb einer Zeitspanne sichergestellt ist, die der seriellen Übertragungsdauer einer Anzahl von Bits entsprechend der Bit-Länge des S/P-P/S-Umsetzers, entspricht, hier nicht näher dargestellte Zwischenregister vorgesehen werden müssen. Diese Zwischenregister, deren Realisierung im Können eines Durchschnittsfachmannes liegt, stellen im Falle der Seriell/Parallel-Umsetzung sicher, daß die Daten rechtzeitig übernommen werden bzw. im Falle der Parallel/Seriell-Umsetzung, daß die Daten rechtzeitig bereitgestellt werden.

Für die Parallel/Seriell-Umsetzung bzw. die Seriell/Parallel-Umsetzung kann zur Einzalansteuerung der Register Reg1..Regn in einem Steuerbus SB jeweils eine Anzahl Steuerleitungen entsprechend der Anzahl von Registern (beispielsweise 64 Register) vorgesehen sein, die die Ablaufsteuerung CTR mit den einzelnen Registern Reg1..Regn verbinden.

Die Anzahl der im Steuerbus SB enthaltenen Steuerleitungen läßt sich reduzieren, wenn entsprechend Fig. 2 die Steuersignale zur Ansteuerung der Register Reg1..Regn von einer zentralen Steuerung binär codiert zu registerindividuellen Decodern Dec1..Decn übertragen werden. Gemäß FIG 2 beinhaltet die zentrale Steuerung einen Teiler DIV und einen Zähler COU. Der Teiler DIV, der das Taktsignal CLK in einem Verhältnis heruntersetzt, das der Bit-Länge des Seriell/Parallel/Parallel/Seriell-Umsetzers entspricht (beispielsweise um den Faktor 8), kann beispielsweise mit einem im Ring geschlossenen Schieberegister, bestehend aus einer der Länge des S/P-P/S-Umsetzers entsprechenden Anzahl von Schieberegisterstufen, gebildet sein, das von einem vor der Umsetzung des Datenwortes herrschenden Grundzustand aus mit dem Taktsignal CLK getaktet, ein logisches HIGH- (oder LOW-)Signal durchschiebt; an zwei Schieberegisterstufen sind dabei zwei Eingänge RD und LD eines vorzugsweise mit elektronischen Mitteln ausgeführten Umschalters US angeschlossen.

Im Falle einer Seriell/Parallel-Umsetzung wird - bei der aus FIG 2 ersichtlichen Schalterstellung S/P des Umschalters US -zuerst das am Umschaltereingang RD auftretende Signal an den Seriell/Parallel-Parallel/Seriell-Umsetzer abgegeben, wo es die Ausgabe des Speicherinhalts des Seriell/Parallel-Parallel/Seriell-Umsetzers auf den Datenbus DB bewirkt; danach wird das am Umschaltereingang LD auftretende Signal zum einen sämtlichen Decodern Dec1..Decn zugeführt und zum anderen als Taktsignal für einen Zähler COU genützt, der ausgehend von einem zu Beginn der Datenwortumsetzung vorliegenden Grundzustand bis zu einem Zählerstand zählt, der der Anzahl n der Register Reg1..Regn entspricht, und der den jeweiligen aktuellen Zählerstand binär codiert über den mit Steuerleitungen SB1..SBm und gegenüber diesen Steuerleitungen SB1..SBm das invertierte Signal führenden Steuerleitungen $\overline{SB1}$..$\overline{SBm}$ gebildeten Steuerbus SB den Decodern Dec1..Decn zuführt. Erkennt ein Decoder Dec1..Decn den jeweiligen registerindividuellen Code auf dem Steuerbus SB und tritt gleichzeitig das LD-Signal auf, so wird auf der jeweiligen Leitung L1..Ln ein Signal zur Übernahme der auf dem Datenbus DB anstehenden Daten an das jeweilige Register Reg abgegeben.

Im Falle einer Parallel/Seriell-Umsetzung wird das RD-Signal einerseits sämtlichen Decodern Dec1..Decn zugeführt und andererseits dient es dem Zähler COU als Taktsignal, der wiederum den aktuellen Zählerstand über den Steuerbus SB, den Decodern Dec1..Decn zuführt. Tritt gleichzeitig der jeweilige registerindividuelle Code und das RD-Signal an einem Decoder Dec1..Decn auf, so gibt dieser ein Signal R1..Rn zur Ausgabe des Registerinhalts des betreffenden Registers Reg1..Regn auf den Datenbus DB ab. Der Seriell/Parallel-Parallel/Seriell-Umsetzer übernimmt mit dem LD-Signal die auf dem Datenbus DB anstehenden Daten und schiebt sie anschließend über den seriellen Datenanschluß DSO mit dem Taktsignal CLK getaktet aus.

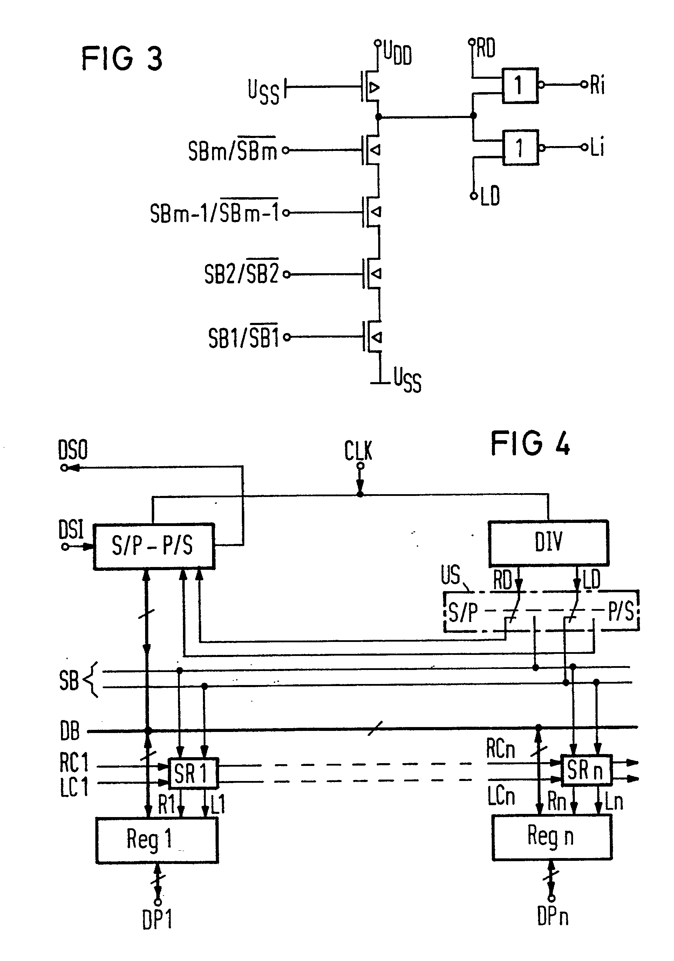

Wie die Decoder Dec1..Decn schaltungstechnisch realisiert sein können, ist in Fig. 3 dargestellt. Die Decoder Dec1..Decn sind jeweils mit der Serienschaltung einer Mehrzahl von Transistoren gebildet, wobei die äußeren Transistoren mit ihrer der Serien schaltung abgewandten Hauptelektrode jeweils mit einem Anschluß $U_{DD}$, $U_{SS}$ der Betriebsspannungsquelle $U_{DD}$-$U_{SS}$ verbunden sind. Der eine Transistor, der mit seiner einen Hauptelektrode mit dem das hohe Potential $U_{DD}$ führenden Anschluß der Betriebsspannungsquelle $U_{DD}$-$U_{SS}$ verbunden ist, ist vorzugsweise ein selbstsperrender Feldeffekttransistor vom p-Kanal Typ, der mit seiner Steuerelektrode mit dem das niedrige Potential aufweisenden Anschluß $U_{SS}$ der Betriebsspannungsquelle $U_{DD}$-$U_{SS}$ verbunden ist und somit wie ein Arbeitswiderstand wirkt. Die übrigen Transistoren der Serienschaltung sind vorzugsweise vom selbstsperrenden n-Kanal-Typ und werden an ihren Steuerelektroden jeweils mit einer Steuerleitung SB1..SBm oder einer gegenüber der jeweiligen Steuerleitung SB1..SBm das invertierte Signal führenden Steuerleitung $\overline{SB1}$..$\overline{SBm}$ verbunden.

Sind sämtliche n-Kanal-Transistoren der Serienschaltung an ihren Steuerelektroden mit einem HIGH-Signal beaufschlagt, so erfolgt an der Verbindung der Hauptelektrode des p-Kanal-Transistors mit der Hauptelektrode des benachbarten n-Kanal-Transistors ein Signalzustandswechsel (im Beispiel von HIGH nach LOW), der über eine Verbindung zu jeweils einem Eingang von zwei die logische NOR-Funktion realisierenden Gattern führt. Damit es genau dann zu diesem Signalzustandswechsel kommt, wenn ein binärer Zählerstand des Zählers COU erreicht ist, der dem jeweiligen registerindividuellen Code entspricht, werden die jeweiligen Steuerelektroden der jeweiligen n-Kanal-Transistoren mit einer Steuerleitung SB1..SBm einer Wertigkeit des Binärcodes oder einer das inverse Signal führenden komplementären Steuerleitung $\overline{SB1}$ ..$\overline{SBm}$ verbunden, die bei Vorliegen des jeweiligen registerindividuellen Codes gerade ein HIGH-Signal führt. Das von der Serienschaltung an die NOR-Gatter abgegebene Signal wird jeweils mit einem im LOW-Zustand den aktiven Zustand angebenden RD-Signal bzw. LD-Signal verknüpft. Im Fall der Seriell/Parallel-Umsetzung bewirkt das jeweilige (im Beispiel HIGH-aktive) Ausgangssignal L1..Ln des jeweiligen NOR-Gatters die Übernahme der auf dem Datenbus DB anstehenden Information in das jeweilige Register Reg1..Regn, wohingegen im Fall der Parallel/Seriell-Umsetzung das (im Beispiel HIGH-aktive) Ausgangssignal R1..Rn des jewei ligen NOR-Gatters eine Ausgabe des im jeweiligen Registers Reg1 ..Regn enthaltenen Registerinhalts auf den Datenbus DB bewirkt.

Die mit Transistoren gebildete, die logische NAND-Funktion realisierende Serienschaltung braucht dann keine besonderen Anforderungen an die Schaltgeschwindigkeit zu erfüllen, wenn die Signaländerungen an den Steuerelektroden der n-Kanal-Transistoren der Serienschaltung so rechtzeitig erfolgt, daß das Signal an der Verbindung vom p-Kanal-Transistor mit dem benachbarten n-Kanal-Transistor einen stabilen Zustand eingenommen hat, wenn das LD-Signal bzw. das RD-Signal auftritt.

Eine Alternative zu der oben beschriebenen Ansteuerung der Register Reg1..Regn ist in Fig. 4 dargestellt. Der nur einen Bruchteil der gesamten Datenwortlänge aufnehmende S/P-P/S-Umsetzer ist wiederum über einen Datenbus DB mit sämtlichen Registern Reg1..Regn verbunden und bekommt ebenso wie ein Teiler DIV ein Taktsignal CLK zugeführt. Der· Teiler DIV, der wiederum mit einem Schieberegister gebildet sein kann, teilt das Taktsignal CLK durch einen Faktor entsprechend der Länge des S/P-P/S-Umsetzers und stellt das RD-Signal und das LD-Signal bereit. Die Steuerung der Register Reg1..Regn erfolgt in diesem Ausführungsbeispiel durch ein Steuer-Schieberegister, dessen Steuer-Schieberegisterstufen SR1..SRn jeweils einem Register Reg1..Regn zugeordnet sind.

Im Falle einer Seriell/Parallel-Umsetzung wird bei der aus FIG 4 ersichtlichen Schalterstellung S/P des Umschalters US zuerst das am Umschaltereingang RD auftretende RD-Signal an den Seriell/Parallel-Parallel/Seriell-Umsetzer abgegeben, wo es die Ausgabe des Speicherinhalts des Seriell/Parallel-Parallel/Seriell-Umsetzers auf den Datenbus DB bewirkt; danach wird das am Umschaltereinang LD auftretende LD-Signal sämtlichen Schieberegisterstufen SR1..SRn zugeführt. Ein zu Beginn der Seriell/Parallel-Umsetzung eines Datenwortes am Eingang LC1 der Schieberegisterstufe SR1 anstehendes, den aktiven Zustand kennzeichnendes (beispielsweise HIGH-) Registerfreigabesignal bedingt bei gleich zeitigem Auftreten des LD-Signals ein Signal L1 zur Übernahme der auf dem Datenbus DB befindlichen Signale in das Register Reg1. Das jeweilige am Eingang LC1..LCn der jeweiligen Schieberegisterstufen SR1..SRn anstehende Signal wird mit dem LD-Signal als Takt zu dem entsprechenden Eingang der nächstfolgenden Steuer-Schieberegisterstufe SR weitergeschoben, so daß die Datenwortabschnitte mit dem LD-Signal als Takt nacheinander in die Register Reg1..Regn übernommen werden und schließlich das ganze umgesetzte Datenwort an den parallelen Datenanschlüssen DP1.. DPn ansteht.

Im Falle einer Parallel/Seriell-Umsetzung wird das RD-Signal über den in der Schalterstellung P/S befindlichen Umschalter US sämtlichen registerindividuellen Steuer-Schieberegisterstufen SR1..SRn zugeführt. Das zu Beginn der Parallel/Seriell-Umsetzung eines Datenwortes am Eingang RC1 der Steuer-Schieberegisterstufe SR1 den aktiven Zustand kennzeichnende (beispielsweise HIGH-) Registerfreigabesignal bedingt bei gleichzeitigem Auftreten des RD-Signals ein Signal R1 zur Ausgabe des Datenwortabschnitts des Registers Reg1 auf den Datenbus DB. Mit dem LD-Signal übernimmt der Seriell/Parallel-Parallel/Seriell-Umsetzer diesen Datenwortabschnitt und liest ihn mit dem Taktsignal CLK an dem seriellen Datenausgang DSO aus. Das jeweilige am Eingang RC1..RCn der jeweiligen Schieberegisterstufe SR1..SRn anstehende Signal wird mit dem RD-Signal als Takt zu dem entsprechenden Eingang RC der nächstfolgenden Schieberegisterstufe weitergeschoben, so daß bei Auftreten des nächsten RD-Signals jeweils der Datenwortabschnitt des nächstfolgenden Registers Reg umgesetzt wird und schließlich das umzusetzende Datenwort in seiner gesamten Länge in serieller Struktur am seriellen Datenanschluß DSO erscheint.

Zu Beginn der oben beschriebenen erfindungsgemäßen Datenwortumsetzung nach Fig. 4 wird der jeweilige Eingang RC1 bzw. LC1 der Steuer-Schieberegisterstufe SR1 mit einem den aktiven Zustand kennzeichnenden Registerfreigabesignal erneut beaufschlagt. Alternativ dazu kann aber auch der jeweilige Eingang RC1 bzw. LC1 der Steuer-Schieberegisterstufe SR1 mit dem jeweils entspre chenden Ausgang der Steuer-Schieberegisterstufe SRn verbunden werden, so daß das Registerfreigabesignal im Ring geschoben wird.

Die Schieberegisterstufen SR1..SRn können in an sich bekannter Weise jeweils mit einem statischen Flip-Flop gebildet sein, wobei das Ausgangssignal des jeweiligen Flip-Flops einerseits das Eingangssignals des nächstfolgenden Flip-Flops bildet und andererseits durch Verknüpfung mit dem gleichzeitig als Taktsignal wirkenden RD-Signal das jeweilige R1-...Rn-Signal bildet bzw. nach Verknüpfung mit dem gleichzeitig als Taktsignal wirkenden LD-Signal das jeweilige L1-...Ln-Steuersignal bildet.

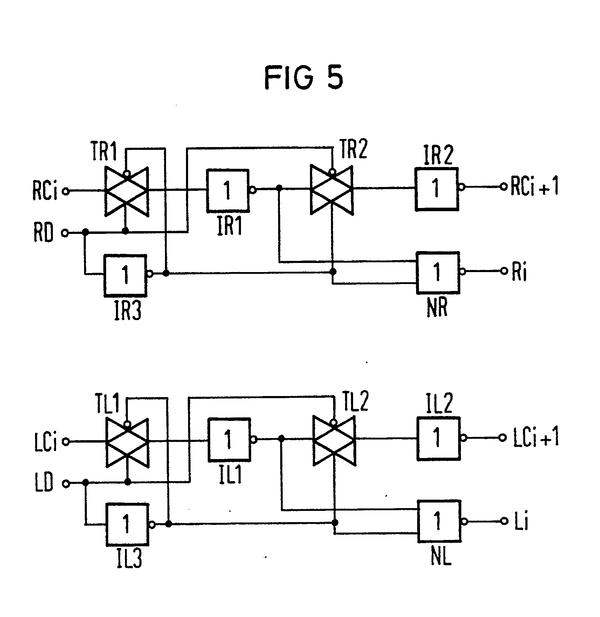

Die Steuer-Schieberegisterstufen SR1..SRn können aber auch, wie dies in Fig. 5 dargestellt ist, mit dynamischen Schieberegisterstufen gebildet sein, wobei für die Seriell/Parallel-Umsetzung und die Parallel/Seriell-Umsetzung jeweils ein gleichartiger Schaltungsaufbau zur Anwendung kommt, so daß die Beschreibung des Steuer-Schieberegisteraufbaus für die Parallel/Seriell-Umsetzung genügt. Eine Steuer-Schieberegisterstufe SR für die Parallel/Seriell-Umsetzung ist jeweils mit der Serienschaltung eines Transmission-Gates TR1 eines Inverters IR1, eines weiteren Transmission-Gates TR2 und eines weiteren Inverters IR2 gebildet, wobei die Tansmission-Gates TR1, TR2 mit dem RD-Signal und dem, beispielsweise mit Hilfe eines Inverters IL3 gewonnenen, invertierten RD-Signal jeweils gegensinnig angesteuert werden; das Ausgangssignal des Inverters IR1 und das invertierte RD-Signal werden in einem die logische NOR-Funktion realisierenden Gatter NR verknüpft, so daß an dessen Ausgang das jeweilige Ri-Steuersignal zur Verfügung steht.

Bei der Ausführungsform der Steuer-Schieberegisterstufen SR1.. SRn entsprechend Fig. 5 wird der dynamische Speichereffekt ausgenutzt, der an den Eingängen der den jeweiligen Transmission-Gates nachgeschalteten Invertern IR1,IR2 auftritt und der bewirkt, daß nach dem Hochohmigwerden des vorgeschalteten Transmission-Gates das Eingangssignal der genannten Inverter für eine gewisse Zeitspanne erhalten bleibt.

Durch ein entsprechendes RD-Signal (im Beispiel HIGH-Signal) wird das Transmission-Gate TR1 niederohmig geschaltet, womit das am Eingang RCi anliegende (beispielsweise HIGH-)Registerfreigabesignal über den Inverter IR1 invertiert an den Eingang des bei Vorliegen dieser Steuersignale hochomig geschalteten Transmission-Gate TR2 und an einen Eingang des NOR-Gatters NR gelangt. Das in dem Inverter IR3 invertierte RD-Signal sperrt im gegebenen Fall das Transmission-Gate TR2 und beaufschlagt gleichzeitig das NOR-Gatter NR eingangsseitig, wodurch dieses am Ausgang im gegebenen Fall an das zugehörige Register Reg ein Ri-Steuersignal abgibt. Durch einen Signalübergang des RD-Signals (im Beispiel nach LOW) wird das Transmission-Gate TR1 hochohmig, während das Transmission-Gate TR2 niederohmig wird. Nachdem das jeweilige, dem jeweiligen Inverter IR1,IR2 vorgeschaltete Transmissions-Gate TR1, TR2 hochohmig wurde, bleibt der zuvor anliegende Eingangszustand, bedingt durch die parasitäre Eingangskapazität, für eine gewisse Zeitspanne an den Eingängen der Inverter IR1, IR2 erhalten. Dadurch steht im obenbeschriebenen Fall weiterhin ein LOW-Signal am Ausgang des Inverters IR1, das über das niederohmige Transmission-Gate TR2 an den Eingang des Inverters IR2 gelangt und an dessen Ausgang als HIGH-Signal an den Eingang der nachfolgenden Steuer-Schieberegisterstufe SR gelangt. Die Steuer-Schieberegisterstufe SR für die Seriell/Parallel-Umsetzung (TL1, IL1, TL2, IL2, IL3, NL) arbeitet in prinzipiell gleicher Weise und muß deshalb hier nicht näher beschrieben werden.

Die Steuerung der Register Reg1..Regn mit jeweils gleichen registerindividuellen Steuer-Schieberegisterstufen SR1..SRn bringt den Vorteil einer erheblichen Reduzierung der erforderlichen Steuerleitungen und einer einfachen modularen Erweiterbarkeit.

**Ansprüche**

1. Schaltungsanordnung zur Umsetzung von in paralleler Struktur vorliegenden Datenworten in in serieller Struktur vorliegende Datenworte und/oder umgekehrt unter Einsatz eines Schieberegisters (S/P-P/S) mit seriellem Anschluß (DSI, DSO) und parallelem Anschluß, einem Datenbus (DB), der den parallelen Anschluß mit einer Anzahl von Registern (Reg1..Regn) verbindet, einer Mehrzahl von Steuerleitungen (SB) und einer Ablaufsteuerung (CTR);
**dadurch gekennzeichnet,**
daß das umzusetzende Datenwort durch die Ablaufsteuerung (CTR) in Abschnitte geteilt wird, die einerseits kleiner als die Datenwortlänge sind und andererseits der Länge des Schieberegisters (S/P-P/S) entsprechen, wobei diese Datenwortabschnitte nacheinander in dem Schieberegister (S/P-P/S) umgesetzt werden.

2. Schaltungsanordnung nach Anspruch 1,
**dadurch gekennzeichnet,**
daß die Signale zur Steuerung der Register (Reg1..Regn) binär codiert zu den Registern (Reg1..Regn) übertragen werden und dort decodiert werden.

3. Schaltungsanordnung nach Anspruch 1,
**dadurch gekennzeichnet,**
daß die Register (Reg1..Regn) dadurch nacheinander angesteuert werden, daß ein Registerfreigabesignal durch registerindividuelle, das jeweilige Register (Reg1..Regn) steuernde Steuer-Schieberegisterstufen (SR1..SRn) geschoben wird.

4. Schaltungsanordnung nach Anspruch 3,
**dadurch gekennzeichnet,**
daß der ersten Steuer-Schieberegisterstufe (SR1) zu Beginn einer Datenwortumsetzung das Registerfreigabesignal zugeführt wird.

5. Schaltungsanordnung nach Anspruch 4,

**dadurch gekennzeichnet,**

daß die Steuer-Schieberegisterstufen (SR1..SRn) ein im Ring geschlossenes Schieberegister bilden.

6. Schaltungsanordnung nach einem der Ansprüche 4 oder 5,

**dadurch gekennzeichnet,**

daß die Steuer-Schieberegisterstufen (SR1..SRn) jeweils mit der Serienschaltung eines ersten Transmission-Gate (TR1, TL1), eines ersten Inverters (IR1, IL1), eines zweiten Transmission-Gates (TR2, TL2) und eines zweiten Inverters (IR2, IL2) gebildet ist, wobei das zweite Transmission-Gate (TR2, TL2) mit den gegenüber dem ersten Transmission-Gate (TR1, TL1) zugeführten Steuersignalen komplementären Steuersignalen gesteuert wird.

FIG 1

FIG 2

## FIG 3

## FIG 4

# FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 251 151 (INTEGRATED DEVICE TECHNOLOGY) * Spalte 2, Zeilen 1-40; Spalte 3, Zeile 1 - Spalte 11, Zeile 41; Figur 1 * | 1-4 | H 03 M 9/00 |
| A | | 5-6 | |
| A | US-A-4 369 504 (HANMURA) --- | | |
| A | ELECTRONIC DESIGN, Band 35, Nr. 4, 19. Februar 1987, Seite 40, Hasbrouck Heights, NJ, US; D. BURSKY: "FIFO registers with more I/O make better system glue" --- | | |
| A | E.D.N. ELECTRICAL DESIGN NEWS, Band 32, Nr. 6, 18. März 1987, Seiten 65,67-70,72,74, Newton, MA, US; P. HAROLD: "Memory-based CMOS FIFO buffers sport large capacities, rival the speed of bipolars" --- | | RECHERCHIERTE SACHGEBIETE (Int. Cl.5) |
| A | ELEKTRONIK, Band 37, Nr. 19, 16. September 1988, Seiten 63-68, München, DE; K. SCHRÖDINGER: "Modulares optisches Übertragungssystem für Datenraten bis 200 Mbit/s" ----- | | H 03 M G 06 F |

Der vorliegende Recherchenbericht wurde für alle Patentansprüche erstellt

| Recherchenort | Abschlußdatum der Recherche | Prüfer |
|---|---|---|
| DEN HAAG | 11-06-1990 | SEGAERT P.A.O.M.P. |